# EUROPEAN PATENT SPECIFICATION

(11) **EP 3 200 244 B1**
(45) Date of publication and mention of the grant of the patent: **27.07.2022**
(21) Application number: 17153797.0
(22) Date of filing: 30.01.2017
(51) Int. Cl.: H01L 31/0747

(54) **SOLAR CELL AND SOLAR CELL MODULE**
SOLARZELLE UND SOLARZELLENMODUL
CELLULE SOLAIRE ET MODULE DE CELLULE SOLAIRE

(30) Priority: 01.02.2016 JP 2016017417
(43) Date of publication of application: 02.08.2017
(73) Proprietor: Panasonic Intellectual Property Management Co., Ltd., Osaka-shi, Osaka 540-6207 (JP)
(72) Inventor: Yamada, Hiroyuki, Osaka-shi, Osaka 540-6207 (JP); Yano, Ayumu, Osaka-shi, Osaka 540-6207 (JP); Seno, Minato, Osaka-shi, Osaka 540-6207 (JP)
(74) Representative: Müller-Boré & Partner Patentanwälte PartG mbB

(56) References cited:
- US-A1- 2011 272 012
- US-A1- 2012 222 731
- US-A1- 2015 280 031

## Description

### [Technical Field]

The present invention relates to a solar cell and a solar cell module.

### [Background Art]

Hybrid solar cells having a heterojunction structure of a crystalline semiconductor substrate and an amorphous semiconductor thin film are in practical use.

Patent Literature (PTL) 1 discloses a photovoltaic device which improves interface characteristics between a crystalline semiconductor substrate and an amorphous semiconductor thin film to improve photoelectric conversion characteristics. Specifically, in the photovoltaic device disclosed by PTL 1, a p-type amorphous silicon thin film is laminated above a first principal surface of an n-type single-crystal silicon substrate with a first i-type amorphous silicon thin film being between the n-type single-crystal silicon substrate and the p-type amorphous silicon thin film. On the other hand, an n-type amorphous silicon thin film is laminated above a second principal surface of the n-type single-crystal silicon substrate with a second i-type amorphous silicon thin film being between the n-type single-crystal silicon substrate and the n-type amorphous silicon thin film. In the above configuration, after the second principal surface of the single-crystal silicon substrate is plasma-treated by plasma discharge using a mixed gas of a hydrogen gas and a gas including phosphorus on the second principal surface of the single-crystal silicon substrate, the second i-type amorphous silicon layer is formed. With this, phosphorus is introduced into an interface between the single-crystal silicon substrate and the second i-type amorphous silicon layer.

The above configuration makes it possible to reduce recombination of charge carriers in a semiconductor junction interface between the crystalline semiconductor substrate and the amorphous semiconductor thin film, improve junction characteristics, and to improve the photoelectric conversion characteristics of open-circuit voltage (Voc) etc.

US 2015/280031 A1 discloses a solar cell comprising a silicon substrate which is crystalline; a first silicon oxide layer which is disposed on a first principal surface of the silicon substrate and includes phosphorus as an impurity; and a first amorphous silicon layer which is disposed on the first silicon oxide layer.

### [Citation List]

### [Patent Literature]

[PTL 1] Japanese Unexamined Patent Application Publication No. 2003-324209

### [Summary of Invention]

### [Technical Problem]

In the above conventional photovoltaic device, introducing phosphorus into the second principal surface of the n-type single-crystal silicon substrate causes defects in the second principal surface. These defects in the second principal surface of the single-crystal silicon substrate make it impossible to completely reduce recombination of charge carriers in the second i-type amorphous silicon layer, and there is concern that photoelectric conversion characteristics are deteriorated.

In view of this, the present invention has been conceived to solve the above problem, and an object of the present invention is to provide a solar cell having improved photoelectric conversion characteristics and a heterojunction structure, and a solar cell module.

### [Solution to Problem]

In order to solve the above problem, a solar cell according to one aspect of the present invention includes: a silicon substrate which is crystalline; a first silicon oxide layer which is disposed on a first principal surface of the silicon substrate and includes phosphorus as an impurity; and a first amorphous silicon layer disposed on the first silicon oxide layer, wherein a phosphorous concentration profile in a thickness direction between the first amorphous silicon layer and the silicon substrate has a maximum value in the first silicon oxide layer.

### [Advantageous Effects of Invention]

The silicon oxide layer including phosphorus as the impurity is between the silicon substrate which is crystalline and the amorphous silicon layer in the solar cell or solar cell module according to one aspect of the present invention. Consequently, it is possible to provide the solar cell with improved photoelectric conversion or the solar cell module with improved power generation efficiency.

### [Brief Description of Drawings]

FIG. 1 is a schematic plan view of a solar cell module according to an embodiment;
FIG. 2 is a structural cross-sectional view of the solar cell module according to the embodiment, in a column direction;
FIG. 3 is a plan view of a solar cell according to the embodiment;
FIG. 4 is a schematic cross-sectional view illustrating a laminated structure of the solar cell according to the embodiment;
FIG. 5 is a graph illustrating concentration profiles of oxygen and phosphorus with respect to a depth direction from a silicon substrate to an amorphous silicon layer; and
FIG. 6 is a schematic cross-sectional view illustrating a laminated structure of a solar cell according to a variation of the embodiment.

### [Description of Embodiments]

Hereinafter, a solar cell and a solar cell module according to exemplary embodiments of the present invention will be described in detail with reference to the drawings. The exemplary embodiments described below each show a specific example. Therefore, numerical values, shapes, materials, structural components, the arrangement and connection of the structural components, and steps, etc. shown in the following exemplary embodiments are mere examples, and are not intended to limit the scope of the present invention. Accordingly, among the structural components in the following exemplary embodiments, structural components not recited in any one of the independent claims which indicate the broadest concepts are described as arbitrary structural components.

The respective figures are schematic diagrams and are not necessarily precise illustrations. In addition, in the respective figures, identical structural components are given the same reference signs.

In this DESCRIPTION, a "front surface" of a solar cell denotes a surface which more light can enter inwardly in comparison to a "back surface" which is a surface opposite the front surface (at least 50 to 100% of light enters inwardly from the front surface). Examples of the front surface include a surface which no light enters inwardly from a "back surface" side. In addition, a "front surface" of a solar cell module denotes a surface which light on a side opposite the "front surface" of the solar cell can enter, and a "back surface" of the solar cell module denotes a surface opposite the front surface of the solar cell module. It is to be noted that, unless specifically limited, an expression such as "provide a second member on a first member" is not intended only for a case where the first and second members are provided in direct contact with each other. In other words, examples of this expression include a case where another member is between the first and second members. It is also to be noted that regarding the expression "substantially XX," for example, "substantially the same" is intended to include not only exactly the same but also something that can be substantially recognized as the same.

### [1. Configuration of solar cell module]

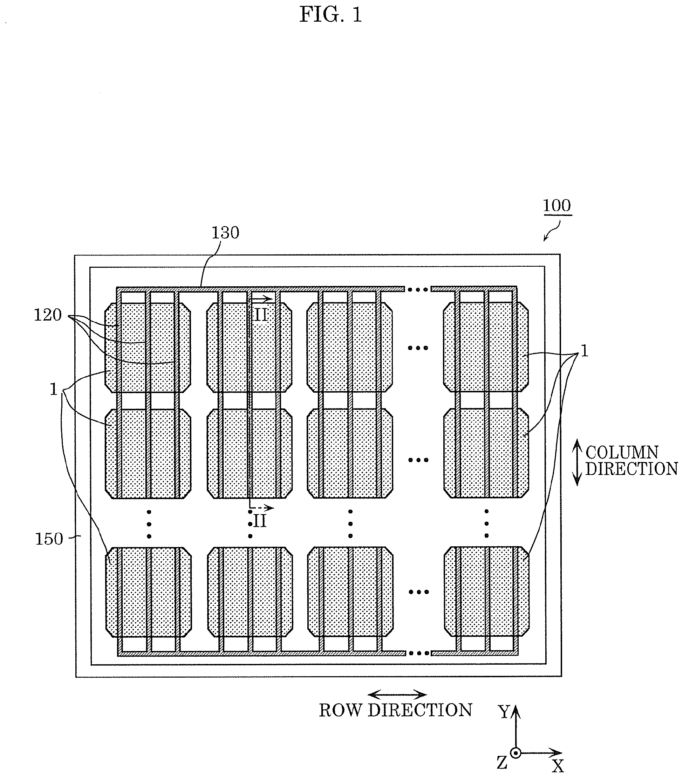

An exemplary plane configuration of a solar cell module according to the embodiment will be described with reference to FIG. 1.

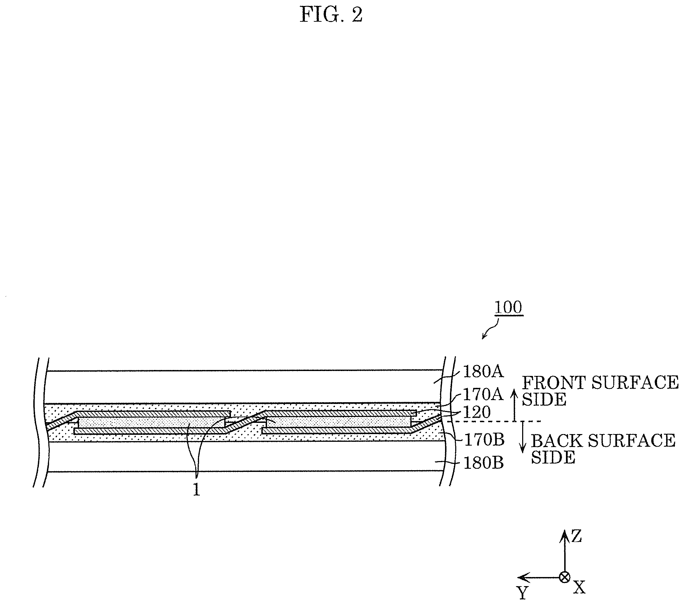

FIG. 1 is a schematic plan view of solar cell module 100 according to the embodiment. FIG. 2 is a structural cross-sectional view of solar cell module 100 according to the embodiment, in a column direction. Specifically, FIG. 2 is a II-II cross-sectional view of solar cell module 100 illustrated by FIG. 1.

As illustrated by FIG. 1, solar cell module 100 includes solar cells 1, tab lines 120, connecting lines 130, and frame 150. In addition, as illustrated by FIG. 2, solar cell module 100 further includes front surface encapsulant member 170A, back surface encapsulant member 170B, front surface protective member 180A, and back surface protective member 180B.

Solar cells 1 are planar photovoltaic elements which are arranged in a matrix on a light-receiving surface and generate electric power in response to light irradiation.

Tab lines 120 each are a line member which is disposed on a front surface of solar cell 1 and electrically connects solar cells 1 neighboring in the column direction. Tab line 120 is a ribbon metal foil, for example. Tab line 120 can be produced, for example, by cutting, into strips having a predetermined length, a metal foil such as a copper foil and a silver foil whose entire surface is covered with solder, silver, etc.

Connecting lines 130 each are a line member connecting solar cell strings. It is to be noted that the solar cell strings each are an aggregate of solar cells 1 arranged in the column direction and connected by tab line 120.

Frame 150 is an outer frame member which covers an outer periphery of a panel on which solar cells 1 are two-dimensionally arrayed.

A light diffusion member may be disposed between neighboring solar cells 1. With this, light entering a gap region between solar cells 1 can be redistributed to solar cells 1, and thus light gathering efficiency of solar cells 1 is increased. Accordingly, it is possible to increase overall photoelectric conversion efficiency of the solar cell module.

As illustrated by FIG. 2, in two solar cells 1 neighboring in the column direction, tab line 120 disposed on a front surface of one of solar cells 1 is also disposed on a back surface of the other of solar cells 1. More specifically, a back surface at one end portion of tab line 120 is bonded to a bus bar electrode on the front surface of the one of solar cells 1, and a front surface at the other end portion of table line 120 is bonded to a bus bar electrode on the back surface of the other of solar cells 1.

Tab line 120 and the bus bar electrode are bonded with an electrically conductive adhesive, for example. Examples of the electrically conductive adhesive include a conductive adhesive paste, a conductive adhesive film, and an anisotropic conductive film. The electrically conductive adhesive paste is, for example, a paste adhesive produced by dispersing conductive particles into a thermosetting adhesive resin material such as an epoxy resin, an acryl resin, and a urethane resin. The electrically conductive adhesive film and the anisotropic conductive film each are a film adhesive produced by dispersing conductive particles into a thermosetting adhesive resin material.

It is to be noted that the aforementioned electrically conductive adhesive may be a solder material. In addition, a resin adhesive including no conductive particle may be used instead of the electrically conductive adhesive. In this case, properly designing an application thickness for the resin adhesive allows the resin adhesive to soften when pressure is applied at the time of thermal compression bonding, and the bus bar electrode and tab line 120 to be electrically connected in direct contact with each other.

Moreover, as illustrated by FIG. 2, front surface protective member 180A is provided on a front surface side of solar cells 1, and back surface protective member 180B is provided on a back surface side of solar cells 1. Front surface encapsulant member 170A is disposed between a surface including solar cells 1 and front surface protective member 180A, and back surface encapsulant member 170B is disposed between a surface including solar cells 1 and back surface protective member 180B. Front surface protective member 180A and back surface protective member 180B are fixed by front surface encapsulant member 170A and back surface encapsulant member 170B, respectively.

Front surface protective member 180A is a translucent substrate which protects a front surface side of solar cell module 100, and protects the inside (solar cells 1 etc.) of solar cell module 100 from an external environment such as wind and rain, external shock, and fire. Front surface protective member 180A is a translucent member having translucency, and is a glass substrate (transparent glass substrate) including a transparent glass material or a resin substrate including a film-like or plate-like hard resin material having translucency and impermeability, for example.

Back surface protective member 180B is a member which protects a back surface of solar cell module 100 and includes, for example, a resin film such as polyethylene terephthalate or a laminated film having a structure in which an Al foil is disposed between resin films.

Front surface encapsulant member 170A and back surface encapsulant member 170B have a sealing function for isolating solar cells 1 from the external environment. Disposing front surface encapsulant member 170A and back surface encapsulant member 170B makes it possible to ensure high heat resistance and high humidity resistance of solar cell module 1 to be installed outdoors.

Front surface encapsulant member 170A and back surface encapsulant member 170B each include a translucent polymer material having a sealing function. Examples of the polymer material of front surface encapsulant member 170A include a translucent resin material such as ethylene-vinyl acetate (EVA).

It is to be noted that in the light of simplification of manufacturing process and interface adherence between front surface encapsulant member 170A and back surface encapsulant member 170B, front surface encapsulant member 170A and back surface encapsulant member 170B may include the same material.

### [2. Structure of solar cell]

The following describes a structure of each solar cell 1 which is a main component of solar cell module 100.

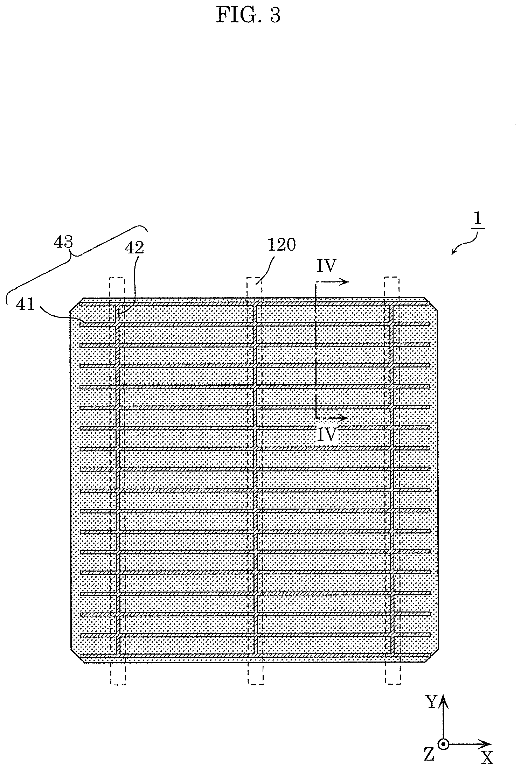

FIG. 3 is a plan view of solar cell 1 according to the embodiment. As illustrated by the figure, solar cell 1 is substantially square in a plan view. Solar cell 1 has a size of 125 mm in length × 125 mm in width × 200 µm in thickness, for example. Moreover, on a surface of solar cell 1, bus bar electrodes 42 having a stripe shape are formed in parallel to each other, and finger electrodes 41 having a stripe shape are formed in parallel to each other to cross bus bar electrodes 42 at right angles. Bus bar electrodes 42 and finger electrodes 41 constitute collector electrode 43. Collector electrode 43 is formed using, for example, a conductive paste including conductive particles such as Ag (silver). It is to be noted that, for example, a line width of bus bar electrodes 42 is 1.5 mm, a line width of finger electrodes 41 is 100 µm, and a pitch of finger electrodes 41 is 2 mm. Furthermore, tab lines 120 are bonded onto bus bar electrodes 42.

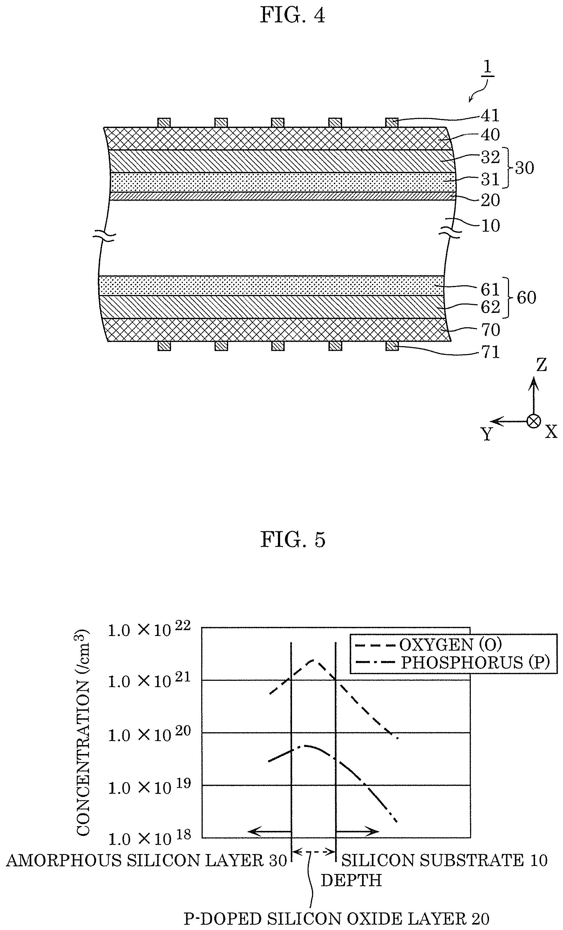

FIG. 4 is a schematic cross-sectional view illustrating a laminated structure of solar cell 1 according to the embodiment. It is to be noted that this figure is a IV-IV cross-sectional view of solar cell 1 illustrated by FIG. 3. As illustrated by FIG. 4, solar cell 1 includes silicon substrate 10, P-doped silicon oxide layer 20, amorphous silicon layers 30 and 60, transparent electrodes 40 and 70, and finger electrodes 41 and 71. It is to be noted that FIG. 4 illustrates only finger electrode 41 included in collector electrode 43.

Silicon substrate 10 is an n-type single-crystal silicon substrate having a first principal surface and a second principal surface which are back to back with each other. It is to be noted that silicon substrate 10 may include polysilicon. Moreover, the first principal surface and the second principal surface each may have a textured structure in which pyramids are two-dimensionally arranged. Furthermore, silicon substrate 10 has an n-type dopant concentration of at least 3 × 10¹⁴/cm³ and at most 9.1 × 10¹⁵/cm³, for example, and a resistivity of at least 0.5 Ωcm and at most 15 Ωcm, for example. In addition, in order to further reduce recombination of charge carriers in silicon substrate 10, silicon substrate 10 preferably has an n-type dopant concentration of at most 3 × 10¹⁵/cm³, and a resistivity of at least 1.5 Ωcm. Additionally, in order to reduce output loss caused by series resistance, silicon substrate 10 preferably has an n-type dopant concentration of at least 3.5 × 10¹4/cm³, and a resistivity of at most 13 Ωcm.

P-doped silicon oxide layer 20 is a first silicon oxide layer disposed on the first principal surface of silicon substrate 10, and includes a silicon oxide film including phosphorus as an impurity. P-doped silicon oxide layer 20 has a thickness of at least 0.1 nm and at most 3 nm, for example. P-doped silicon oxide layer 20 more preferably has a thickness of at most 2 nm. P-doped silicon oxide layer 20 is thinner than dielectric layer 31 and n-type amorphous silicon layer 32 which will be described later. In addition, P-doped silicon oxide layer 20 may be formed into an island shape, in an interface between silicon substrate 10 and amorphous silicon layer 30.

P-doped silicon oxide layer 20 has a phosphorus concentration of at least 1 × 10¹⁹/cm³ and at most 5 × 10²⁰/cm³, and an oxygen atomic concentration of at least 1 × 10²¹/cm³ and at most 2 × 10²²/cm³. P-doped silicon oxide layer 20 more preferably has a phosphorus concentration of at least 5 × 10¹⁹/cm³ and at most 1 × 10²⁰/cm³, and an oxygen atomic concentration of at least 2 × 10²¹/cm³ and at most 5 × 10²¹/cm³. It is to be noted that P-doped silicon oxide layer 20 may be an amorphous layer. In such a case, P-doped silicon oxide layer 20 can be formed at low temperature of at most 200 °C, for example.

Amorphous silicon layer 30 is a first amorphous silicon layer which is formed on a front surface of P-doped silicon oxide layer 20 and is substantially in an amorphous state. Amorphous silicon layer 30 includes dielectric layer 31 and n-type amorphous silicon layer 32.

Dielectric layer 31 is a first dielectric layer formed on the front surface of P-doped silicon oxide layer 20, and is, for example, a first intrinsic amorphous silicon layer which includes hydrogen and is in the amorphous state. Here, an intrinsic amorphous silicon layer denotes an amorphous semiconductor layer having an included p-type or n-type dopant concentration of at most 5 × 10¹⁸/cm³ or an amorphous semiconductor layer having, in a case where both p-type and n-type dopants are included, a difference between a p-type dopant concentration and an n-type dopant concentration which is at most 5 × 10¹⁸/cm³. Dielectric layer 31 may be made thin to reduce absorption of light as much as possible, and at the same time may be made thick to sufficiently passivate a front surface of silicon substrate 10. Dielectric layer 31 has, for example, a film thickness of at least 1 nm and at most 25 nm, and preferably has a film thickness of at least 5 nm and at most 10 nm.

It is to be noted that dielectric layer 31 may not be the intrinsic amorphous silicon layer as described above, and may be a silicon oxide layer, a silicon nitride layer, or an aluminum oxide layer. Moreover, dielectric layer 31 may not be present, and n-type amorphous silicon layer 32 may be directly formed on the front surface of P-doped silicon oxide layer 20.

N-type amorphous silicon layer 32 is a first conductive amorphous silicon layer which is formed on dielectric layer 31, includes dopants of n-type which is the same as a conductivity type of silicon substrate 10, and is substantially in the amorphous state. N-type amorphous silicon layer 32 includes, for example, an amorphous silicon semiconductor thin film including hydrogen. N-type amorphous silicon layer 32 has a higher n-type dopant concentration in a film than dielectric layer 31, and preferably has an n-type dopant concentration of at least 1 × 10²⁰/cm³. Examples of the dopants of n-type include phosphorus (P). N-type amorphous silicon layer 32 may be made thin to reduce absorption of light as much as possible, and at the same time may be made thick to effectively separate charge carriers generated in silicon substrate 10 and to allow transparent electrode 40 to efficiently collect the generated charge carriers. It is to be noted that n-type amorphous silicon layer 32 has the n-type dopant concentration which may gradually change from a side of P-doped silicon oxide layer 20 to a side of transparent electrode 40.

Amorphous silicon layer 60 is a second amorphous silicon layer which is disposed on the second principal surface of silicon substrate 10 and is substantially in the amorphous state. Amorphous silicon layer 60 includes dielectric layer 61 and p-type amorphous silicon layer 62.

Dielectric layer 61 is a second dielectric layer formed on the second principal surface of silicon substrate 10, and is, for example, a second intrinsic amorphous silicon layer which includes hydrogen and is in the amorphous state. Like dielectric layer 31, dielectric layer 61 has, for example, a film thickness of at least 1 nm and at most 25 nm, and preferably has a film thickness of at least 5 nm and at most 10 nm.

It is to be noted that dielectric layer 61 may not be the intrinsic amorphous silicon layer as described above, and may be a silicon oxide layer, a silicon nitride layer, or an aluminum oxide layer. In addition, dielectric layer 61 may not be present, and p-type amorphous silicon layer 62 may be directly formed on the second principal surface of silicon substrate 10.

P-type amorphous silicon layer 62 is a second conductive amorphous silicon layer which is formed on dielectric layer 61, includes dopants of p-type which is opposite of a conductivity type of silicon substrate 10, and is substantially in the amorphous state. P-type amorphous silicon layer 62 includes, for example, an amorphous silicon semiconductor thin film including hydrogen. P-type amorphous silicon layer 62 has a higher p-type dopant concentration in a film than dielectric layer 61, and preferably has a p-type dopant concentration of at least 1 × 10²⁰/cm³. Examples of the dopants of p-type include boron (B). P-type amorphous silicon layer 62 may be made thin to reduce absorption of light as much as possible, and at the same time may be made thick to effectively separate charge carriers generated in silicon substrate 10 and to allow transparent electrode 70 to efficiently collect the generated charge carriers. It is to be noted that p-type amorphous silicon layer 62 has the p-type dopant concentration which may gradually change from a side of silicon substrate 10 to a side of transparent electrode 70.

It is to be noted that amorphous silicon layer 30, amorphous silicon layer 60, n-type amorphous silicon layer 32, and p-type amorphous silicon layer 62 each may include a microcrystal.

Transparent electrode 40 is formed on a front surface of amorphous silicon layer 30, and collects charge carriers in n-type amorphous silicon layer 32. Moreover, transparent electrode 70 is formed on a back surface of amorphous silicon layer 60, and collects charge carriers in p-type amorphous silicon layer 62. Transparent electrodes 40 and 70 each include, for example, a transparent conductive oxide such as an indium tin oxide (ITO).

It is to be noted that to determine which one of the first principal surface and the second principal surface of silicon substrate 10 is used as a light-receiving surface (surface which mainly introduces light from the outside) is optional.

Moreover, although the conductivity type of silicon substrate 10 is the n-type in the embodiment, the conductivity type of silicon substrate 10 may be the p-type. In this case, p-type amorphous silicon layer 62 of amorphous silicon layer 60 has the same conductivity type as the conductivity type of silicon substrate 10, and thus amorphous silicon layer 60 is the first amorphous silicon layer. In addition, n-type amorphous silicon layer 32 of amorphous silicon layer 30 has a conductivity type opposite of the conductivity type of silicon substrate 10, and thus amorphous silicon layer 30 is the second amorphous silicon layer.

Moreover, although solar cell 1 according to the embodiment is a bifacial solar cell including transparent electrode 70 disposed also on a side of a second principal surface, solar cell 1 may be an unifacial solar cell including, instead of transparent electrode 70, a metal electrode which is not transparent.

FIG. 5 is a graph illustrating concentration profiles of oxygen and phosphorus with respect to a depth direction from amorphous silicon layer 30 to silicon substrate 10. In the graph of FIG. 5, concentrations of oxygen and phosphorus are measured by secondary ion mass spectroscopy (SIMS) in a direction (depth direction) from amorphous silicon layer 30 to silicon substrate 10. Judging from the graph of the figure, absolute maximum points of an oxygen atomic concentration and a phosphorus atomic concentration are present in the depth direction and located at the same depth, and the oxygen atomic concentration is higher by at least one digit than the phosphorus atomic concentration. Accordingly, it is clear that a silicon oxide layer including phosphorus as an impurity (P-doped silicon oxide layer 20) is between amorphous silicon layer 30 and silicon substrate 10. As is obvious from the graph, P-doped silicon oxide layer 20 has the phosphorus atomic concentration of at least 1 × 10¹⁹/cm³ and at most 5 × 10²⁰/cm³, and the oxygen atomic concentration of at least 1 × 10²¹/cm³ and at most 2 × 10²²/cm³.

With a conventional photoelectric conversion device, setting an impurity concentration of a silicon substrate in a heterojunction between a crystalline silicon substrate and an amorphous silicon layer to be a predetermined amount makes it possible to reduce recombination of charge carriers in a junction interface. As a result, it is expected to improve an open-circuit voltage (Voc). However, introducing an impurity (phosphorus) into a front surface of the silicon substrate causes defects in the front surface. These defects in the front surface of the silicon substrate make it impossible to completely reduce recombination of charge carriers in the amorphous silicon layer. Moreover, increasing the impurity concentration of the silicon substrate to further improve photoelectric conversion characteristics results in reducing an electric field strength of the amorphous silicon layer. Consequently, the recombination of the charge carriers in the amorphous silicon layer is increased. Furthermore, recombination via excessive impurities in the amorphous silicon layer is accelerated. In other words, the recombination of the charge carriers in the amorphous silicon layer cannot be completely reduced by merely introducing the impurity into the front surface of the silicon substrate. In addition, a concentration of excessive impurities in the front surface of the silicon substrate increases the defects in the front surface of the silicon substrate, and thus the photoelectric conversion characteristics are deteriorated.

By contrast, with solar cell 1 according to the embodiment, the silicon oxide layer is disposed between amorphous silicon layer 30 and silicon substrate 10, and phosphorus is doped into the silicon oxide layer. To put it differently, P-doped silicon oxide layer 20 including phosphorus as the impurity is disposed between amorphous silicon layer 30 and silicon substrate 10.

In order to improve an open-circuit voltage, it is important to maintain a high degree of amorphousness of amorphous silicon layer 30 in addition to reducing recombination of charge carriers caused by impurity doping. From this point of view, disposing the silicon oxide layer between amorphous silicon layer 30 and silicon substrate 10 makes it possible to suppress, in amorphous silicon layer 30, epitaxial growth reflecting crystallinity of silicon substrate 10. Moreover, instead of an impurity, P-doped silicon oxide layer 20 is disposed in the junction interface, and thus it is possible to reduce the increasing of the defects in the front surface of silicon substrate 10. With this, it is possible to improve the open-circuit voltage.

In sum, with solar cell 1 according to the embodiment, disposing the silicon oxide layer including phosphorus as the impurity between amorphous silicon layer 30 and silicon substrate 10 makes it possible to reduce the recombination of the charge carriers in the interface and suppress the epitaxial growth in amorphous silicon layer 30. Accordingly, since it is possible to ameliorate field effect, the improvement of the open-circuit voltage which cannot be achieved by merely doping impurity elements into the silicon substrate can be achieved, or it is possible to improve the open-circuit voltage without degrading photoelectric conversion performance which depends on the defects in the front surface of the silicon substrate.

### [3. Structure of solar cell according to variation]

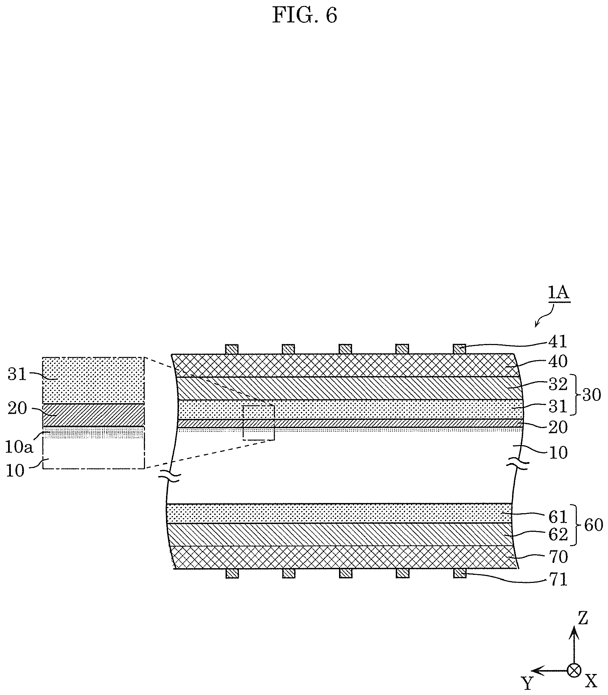

FIG. 6 is a schematic cross-sectional view illustrating a laminated structure of solar cell 1A according to a variation of the embodiment. As illustrated by this figure, solar cell 1A according to the variation differs from solar cell 1 according to the embodiment in that diffusion region 10a of phosphorus is in a front surface (first principal surface) of silicon substrate 10. In other words, in solar cell 1A according to the variation, silicon substrate 10 has, in the first principal surface, diffusion region 10a including phosphorus as an impurity. In this regard, however, diffusion region 10a has a phosphorus atomic concentration lower than a phosphorus atomic concentration of p-doped silicon oxide layer 20. Moreover, diffusion region 10a has, for example, a phosphorus atomic concentration of at least 5 × 10¹⁶/cm³ and at most 5 × 10²⁰/cm³, which is higher than an n-type dopant concentration of silicon substrate 10. Furthermore, a depth of diffusion region 10a from the front surface of silicon substrate 10 is at most 1.5 µm, for example. With this configuration, P-doped silicon oxide layer 20 is between amorphous silicon layer 30 and silicon substrate 10, and thus it is possible to reduce recombination of charge carriers on a side of the first principal surface of silicon substrate 10 and suppress epitaxial growth in amorphous silicon layer 30. Accordingly, it is possible to achieve the improvement of the open-circuit voltage. It is to be noted that a diffusion region of phosphorus may be in a second principal surface of silicon substrate 10.

In addition, the diffusion region in the variation is not limited to a region formed using a thermal diffusion method, and examples of the diffusion region in the variation include a region formed using a plasma doping method, an epitaxial growth method, an ion implantation method, or the like.

### [4. Method for manufacturing solar cell]

Next, a method for manufacturing solar cell 1 including characteristic p-doped silicon oxide layer 20 described above will be described.

First, silicon substrate 10 is washed, placed in a vacuum chamber, and heated to at most 200 °C to remove moisture on a front surface of the substrate as much as possible.

Next, a hydrogen gas is introduced into the vacuum chamber, and the front surface of the substrate is cleaned by plasma discharge. This process has an effect of reducing an amount of carbon of the surface of the substrate.

Next, P-doped silicon oxide layer 20, dielectric layer 31 (first intrinsic amorphous silicon layer), and n-type amorphous silicon layer 32 are sequentially formed on the first principal surface of silicon substrate 10 whose front surface is cleaned, by chemical vapor deposition (CVD), for example. P-doped silicon oxide layer 20 is formed by introducing, into a vacuum deposition chamber, a silicon-containing gas such as silane (SiH₄), an n-type dopant-containing gas such as phosphine (PH₃), and an oxygen-containing gas such as O₂, H₂O, and CO₂, for example. Dielectric layer 31 (first intrinsic amorphous silicon layer) is formed by introducing, into the vacuum deposition chamber, the silicon-containing gas such as silane (SiH₄), for example. N-type amorphous silicon layer 32 is formed by introducing, into the vacuum deposition chamber, a silane (SiH₄) gas and the n-type dopant-containing gas such as phosphine (PH₃), for example.

Next, dielectric layer 61 (second intrinsic amorphous silicon layer) and p-type amorphous silicon layer 62 are sequentially formed on the second principal surface of silicon substrate 10, by CVD, for example. Dielectric layer 61 (second intrinsic amorphous silicon layer) is formed by introducing, into the vacuum deposition chamber, the silicon-containing gas such as the silane (SiH₄) gas, for example. P-type amorphous silicon layer 62 is formed by introducing, into the vacuum deposition chamber, the silane (SiH₄) gas and a p-type dopant-containing gas such as diborane (B₂H₆), for example.

It is to be noted that the gases introduced in each of the manufacturing steps may be gases diluted with the hydrogen gas etc.

Through the above steps, P-doped silicon oxide layer 20 and amorphous silicon layer 30 are formed on the first principal surface of silicon substrate 10, and amorphous silicon layer 60 is formed on the second principal surface of silicon substrate 10.

Next, transparent electrode 40 is formed on a front surface of amorphous silicon layer 30, and transparent electrode 70 is formed on a back surface of amorphous silicon layer 60. Specifically, a transparent conductive oxide such as an indium tin oxide (ITO) is deposited as a film on each of a front surface of n-type amorphous silicon layer 32 and a back surface of p-type amorphous silicon layer 62 by vapor deposition, sputtering, etc.

Finally, collector electrode 43 (metal electrode) including finger electrodes 41 is formed on transparent electrode 40, and a collector electrode (metal electrode) including finger electrodes 71 is formed on transparent electrode 70. The collector electrodes can be formed by, for example, a printing method such as a screen printing method with a thermosetting resin conductive paste using a resin material as a binder and conductive particles such as silver particles as a filler.

Solar cell 1 according to the embodiment is formed through the above steps.

It is to be noted that in the aforementioned method for manufacturing solar cell 1, silicon substrate 10 may again be washed and cleaned by plasma discharge after n-type amorphous silicon layer 32 is formed and before dielectric layer 61 is formed.

Moreover, a textured structure in which pyramids are tow-dimensionally arranged may be previously formed in at least one of the first principal surface and the second principal surface of silicon substrate 10.

Specifically, silicon substrate 10 is soaked in an etching solution. The etching solution is, for example, an alkaline aqueous solution including at least one of sodium hydroxide (NaOH), potassium hydroxide (KOH), and tetramethyl ammonium hydroxide (TMAH). For example, the first principal surface and the second principal surface of silicon substrate 10 are anisotropically etched along a (111) plane by soaking a (100) plane of silicon substrate 10 in the above alkaline aqueous solution. As a result, a textured structure in which square pyramids are two-dimensionally arranged is formed in each of the first principal surface and the second principal surface of silicon substrate 10.

Forming ridges and troughs referred to as the textured structure in which the pyramids are two-dimensionally arranged in the light-receiving surface of solar cell 1 makes it possible to increase light entering inside solar cell 1 by reducing reflected light and to raise power generation efficiency of solar cell 1.

### [5. Advantageous effects etc.]

Solar cell 1 according to the embodiment includes: silicon substrate 10 which is crystalline and has a first conductivity type (n-type); P-doped silicon oxide layer 20 which is disposed on the first principal surface of silicon substrate 10 and includes phosphorus as the impurity; and amorphous silicon layer 30 disposed on p-doped silicon oxide layer 20.

With a conventional photoelectric conversion device, setting an impurity concentration of a silicon substrate in a heterojunction between a crystalline silicon substrate and an amorphous silicon layer to be a predetermined amount makes it possible to reduce recombination of charge carriers in a junction interface. As a result, it is expected to improve an open-circuit voltage (Voc). However, introducing an impurity (phosphorus) into a front surface of the silicon substrate causes defects in the front surface. These defects in the front surface of the silicon substrate make it impossible to completely reduce recombination of charge carriers in the amorphous silicon layer. Moreover, increasing the impurity concentration of the silicon substrate to further improve photoelectric conversion characteristics results in reducing an electric field strength of the amorphous silicon layer. Consequently, the recombination of the charge carriers in the amorphous silicon layer is increased. Furthermore, recombination via excessive impurities in the amorphous silicon layer is accelerated. In other words, the recombination of the charge carriers in the amorphous silicon layer cannot be completely reduced by merely introducing the impurity into the front surface of the silicon substrate. In addition, a concentration of excessive impurities in the front surface of the silicon substrate increases the defects in the front surface of the silicon substrate, and thus the photoelectric conversion characteristics are deteriorated.

By contrast, with solar cell 1 according to the embodiment, the silicon oxide layer is disposed between amorphous silicon layer 30 and silicon substrate 10, and the silicon oxide layer includes phosphorus. To put it differently, P-doped silicon oxide layer 20 including phosphorus as the impurity is disposed between amorphous silicon layer 30 and silicon substrate 10.

In order to improve an open-circuit voltage (Voc) of the solar cell, it is important to maintain a high degree of amorphousness of amorphous silicon layer 30. From this point of view, disposing the silicon oxide layer between amorphous silicon layer 30 and silicon substrate 10 makes it possible to suppress, in amorphous silicon layer 30, epitaxial growth reflecting crystallinity of silicon substrate 10. Moreover, P-doped silicon oxide layer 20 is disposed therebetween, and thus it is possible to reduce the increasing of the defects in the front surface of silicon substrate 10. With this, it is possible to improve the open-circuit voltage.

In sum, with solar cell 1 according to the embodiment, disposing P-doped silicon oxide layer 20 between amorphous silicon layer 30 and silicon substrate 10 makes it possible to reduce the recombination of the charge carriers in the interface and suppress the epitaxial growth in amorphous silicon layer 30. Accordingly, the improvement of the open-circuit voltage which cannot be achieved by merely doping impurity elements into silicon substrate 10 can be achieved, or it is possible to improve the open-circuit voltage without degrading photoelectric conversion performance which depends on the defects in the front surface of silicon substrate 10.

Moreover, amorphous silicon layer 30 may include: dielectric layer 31 (first intrinsic amorphous silicon layer) which is substantially intrinsic and disposed on the front surface of p-doped silicon oxide layer 20; and n-type amorphous silicon layer 32 which is disposed on a front surface of dielectric layer 31 and includes a first conductivity type (n-type) dopant.

With this, dielectric layer 31 (first intrinsic amorphous silicon layer) is between silicon substrate 10 and n-type amorphous silicon layer 32. As a result, the recombination of the charge carriers in the junction interface can be reduced, which makes it possible to promote movement of the charge carriers.

Furthermore, in P-doped silicon oxide layer 20, a phosphorus atomic concentration may be at least 1 × 10¹⁹/cm³ and at most 5 × 10²⁰/cm³, and an oxygen atomic concentration may be at least 1 × 10²¹/cm³ and at most 2 × 10²²/cm³.

In addition, in P-doped silicon oxide layer 20, the phosphorus atomic concentration may be at least 5 × 10¹⁹/cm³ and at most 1 × 10²⁰/cm³, and the oxygen atomic concentration may be at least 2 × 10²¹/cm³ and at most 5 × 10²¹/cm³.

Since the oxygen atomic concentration is higher than the phosphorus atomic concentration, P-doped doped silicon oxide layer 20 has a structure in which phosphorus is doped to the silicon oxide as the impurity. With this, it is possible to reduce the recombination of the charge carriers in the above interface and suppress the epitaxial growth in amorphous silicon layer 30. Accordingly, the improvement of the photoelectric conversion characteristics which cannot be achieved by merely doping impurity elements into silicon substrate 10 can be achieved, or it is possible to improve the open-circuit voltage without degrading photoelectric conversion performance which depends on the defects in the front surface of silicon substrate 10.

Moreover, silicon substrate 10 may include, in the first principal surface, diffusion region 10a having a higher phosphorus atomic concentration than silicon substrate 10.

Even with this configuration, P-doped silicon oxide layer 20 is between amorphous silicon layer 30 and silicon substrate 10, and thus it is possible to reduce the recombination of the charge carriers on the side of the first principal surface of silicon substrate 10 and suppress the epitaxial growth in amorphous silicon layer 30. Accordingly, it is possible to achieve the improvement of the open-circuit voltage.

Moreover, solar cell 1 may further include amorphous silicon layer 60 which is disposed on a second principal surface which is back to back with the first principal surface of silicon substrate 10.

Furthermore, amorphous silicon layer 60 may include: dielectric layer 61 (second intrinsic amorphous silicon layer) which is substantially intrinsic and disposed on the second principal surface of silicon substrate 10; and p-type amorphous silicon layer 62 which is disposed on a back surface of dielectric layer 61 and includes a dopant of a second conductivity type (p-type).

Dielectric layer 61 (second intrinsic amorphous silicon layer) is between silicon substrate 10 and p-type amorphous silicon layer 62. As a result, the recombination of the charge carriers in the junction interface can be reduced, which makes it possible to promote movement of the charge carriers.

Moreover, solar cell module 100 according to the embodiment includes: a plurality of solar cells 1 which are two-dimensionally arranged; front surface protective member 180A disposed on a front surface side of solar cells 1; back surface protective member 180B disposed on a back surface side of solar cells 1; front surface encapsulant member 170A disposed between solar cells 1 and front surface protective member 180A; and back surface encapsulant member 170B disposed between solar cells 1 and back surface protective member 180B.

With this, it is possible to reduce the recombination of the charge carriers in the semiconductor junction interface between silicon substrate 10 which is crystalline and amorphous silicon layer 30, and suppress the epitaxial growth in amorphous silicon layer 30. Thus, the open-circuit voltage of solar cells 1 can be improved, which makes it possible to raise the power generation efficiency of solar cell module 100.

### (Other embodiments)

Although solar cell 1 and solar cell module 100 according to the present invention have been described above based on the aforementioned embodiment, the present invention is not limited to the aforementioned embodiment.

For example, although, in solar cell module 100 according to the aforementioned embodiment, solar cells 1 are arranged in a matrix, the arrangement is not limited to the matrix. For example, the arrangement may be circular, linear, or curvilinear.

The scope of the present invention includes embodiments as a result of adding various modifications to the embodiment which are conceived by those skilled in the art, and embodiments obtained by combining structural components and functions in the embodiment in any manner as long as the combinations do not depart from the scope of the present invention, as defined by the claims.

### [Reference Signs List]

- 1, 1A: solar cell
- 10: silicon substrate
- 20: P-doped silicon oxide layer (first silicon oxide layer)
- 30: amorphous silicon layer (first amorphous silicon layer)
- 31: dielectric layer (first intrinsic amorphous silicon layer)
- 32: n-type amorphous silicon layer (first conductive amorphous silicon layer)
- 60: amorphous silicon layer (second amorphous silicon layer)
- 61: dielectric layer (second intrinsic amorphous silicon layer)
- 62: p-type amorphous silicon layer (second conductive amorphous silicon
- layer) 100: solar cell module
- 170A: front surface encapsulant member
- 170B: back surface encapsulant member
- 180A: front surface protective member
- 180B: back surface protective member

## Claims

1. A solar cell (1) comprising:
a silicon substrate (10) which is crystalline;
a first silicon oxide layer (20) which is disposed on a first principal surface of the silicon substrate (10) and includes phosphorus as an impurity; and
a first amorphous silicon layer (30) which is disposed on the first silicon oxide layer,
wherein a phosphorous concentration profile in a thickness direction between the first amorphous silicon layer (30) and the silicon substrate (10) has a maximum value in the first silicon oxide layer (20).

2. The solar cell according to claim 1,
wherein the first amorphous silicon layer (30) includes: a first intrinsic amorphous silicon layer (31) which is substantially intrinsic and disposed on the first silicon oxide layer; and a first conductive amorphous silicon layer (32) which is disposed on the first intrinsic amorphous silicon layer and includes a dopant of a first conductivity type.

3. The solar cell according to claim 1 or 2,
wherein in the first silicon oxide layer (20),
a phosphorus atomic concentration is at least 1 × 10¹⁹/cm³ and at most 5 × 10²⁰/cm³, and an oxygen atomic concentration is at least 1 × 10²¹/cm³ and at most 2 × 10²²/cm³.

4. The solar cell according to claim 1 or 2,
wherein in the first silicon oxide layer (20), a phosphorus atomic concentration is at least 5 × 10¹⁹/cm³ and at most 1 × 10²⁰/cm³, and an oxygen atomic concentration is at least 2 × 10²¹/cm³ and at most 5 × 10²¹/cm³.

5. The solar cell according to any one of claims 1 to 4,
wherein the silicon substrate (10) includes, in the first principal surface, a diffusion region having a higher phosphorus concentration than the silicon substrate.

6. The solar cell according to any one of claims 1 to 5, further comprising
a second amorphous silicon layer (60) which is disposed on a second principal surface of the silicon substrate which is back to back with the first principal surface.

7. The solar cell according to claim 6,
wherein the second amorphous silicon layer (60) includes: a second intrinsic amorphous silicon layer (61) which is substantially intrinsic and disposed on the silicon substrate; and a second conductive amorphous silicon layer (62) which is disposed on the second intrinsic amorphous silicon layer and includes a dopant of a second conductivity type.

8. The solar cell according to claim 1,
wherein the first amorphous silicon layer (30) includes: a first intrinsic amorphous silicon layer (31) which is substantially intrinsic and disposed in contact with the first silicon oxide layer (20);
and a first conductive amorphous silicon layer (32) which is disposed on the first intrinsic amorphous silicon layer and includes a dopant of a first type.

9. A solar cell module (100) comprising:
a plurality of the solar cells (1) according to any one of claims 1 to 8 which are two-dimensionally arranged;
a front surface protective member (180A) disposed on a front surface side of the plurality of the solar cells;
a back surface protective member (180B) disposed on a back surface side of the plurality of the solar cells;
a front surface encapsulant member (170A) disposed between the plurality of the solar cells and the front surface protective member (180A); and
a back surface encapsulant member (170B) disposed between the plurality of the solar cells and the back surface protective member (180B).

## Patentansprüche

1. Solarzelle (1), umfassend:
ein Siliziumsubstrat (10), welches kristallin ist;
eine erste Siliziumoxidschicht (20), welche auf einer ersten Hauptoberfläche des Siliziumsubstrats (10) angeordnet ist, und Phosphor als eine Verunreinigung einschließt; und
eine erste amorphe Siliziumschicht (30), welche auf der ersten Siliziumoxidschicht angeordnet ist,
wobei ein Phosphorkonzentrationsprofil in einer Dickenrichtung zwischen der ersten amorphen Siliziumschicht (30) und dem Siliziumsubstrat (10) einen Maximalwert in der ersten Siliziumoxidschicht (20) aufweist.

2. Solarzelle gemäß Anspruch 1,
wobei die erste amorphe Siliziumschicht (30) einschließt:
eine erste intrinsische amorphe Siliziumschicht (31), welche im Wesentlichen intrinsisch ist und auf der ersten Siliziumoxidschicht angeordnet ist; und eine erste leitfähige amorphe Siliziumschicht (32), welche auf der ersten intrinsischen amorphen Siliziumschicht angeordnet ist und ein Dotiermittel von einem ersten Leitfähigkeitstyp einschließt.

3. Solarzelle gemäß Anspruch 1 oder 2,
wobei in der ersten Siliziumoxidschicht (20) eine Phosphoratomkonzentration mindestens 1 × 10¹⁹/cm³ und höchstens 5 × 10²⁰/cm³ beträgt, und eine Sauerstoffatomkonzentration mindestens 1 × 10²¹/cm³ und höchstens 2 × 10²²/cm³ beträgt.

4. Solarzelle gemäß Anspruch 1 oder 2,
wobei in der ersten Siliziumoxidschicht (20) eine Phosphoratomkonzentration mindestens 5 × 10¹⁹/cm³ und höchstens 1 × 10²⁰/cm³ beträgt, und eine Sauerstoffatomkonzentration mindestens 2 × 10²¹/cm³ und höchstens 5 × 10²¹/cm³ beträgt.

5. Solarzelle gemäß einem der Ansprüche 1 bis 4,
wobei das Siliziumsubstrat (10) in der ersten Hauptoberfläche einen Diffusionsbereich mit einer höheren Phosphorkonzentration als das Siliziumsubstrat einschließt.

6. Solarzelle gemäß einem der Ansprüche 1 bis 5, weiter umfassend:
eine zweite amorphe Siliziumschicht (60), welche auf einer zweiten Hauptoberfläche des Siliziumsubstrats angeordnet ist, welche Rücken an Rücken mit der ersten Hauptoberfläche ist.

7. Solarzelle gemäß Anspruch 6,
wobei die zweite amorphe Siliziumschicht (60) einschließt:
eine zweite intrinsische amorphe Siliziumschicht (61), welche im Wesentlichen intrinsisch ist und auf dem Siliziumsubstrat angeordnet ist; und eine zweite leitfähige amorphe Siliziumschicht (62), welche auf der zweiten intrinsischen amorphen Siliziumschicht angeordnet ist und ein Dotiermittel von einem zweiten Leitfähigkeitstyp einschließt.

8. Solarzelle gemäß Anspruch 1,
wobei die erste amorphe Siliziumschicht (30) einschließt:
eine erste intrinsische amorphe Siliziumschicht (31), welche im Wesentlichen intrinsisch ist und in Kontakt mit der ersten Siliziumoxidschicht (20) angeordnet ist; und eine erste leitfähige amorphe Siliziumschicht (32), welche auf der ersten intrinsischen amorphen Siliziumschicht angeordnet ist und ein Dotiermittel von einem ersten Typ einschließt.

9. Solarzellenmodul (100), umfassend:
eine Vielzahl von Solarzellen (1) gemäß einem der Ansprüche 1 bis 8, die zweidimensional angeordnet sind;
ein Vorderflächen-Schutzelement (180A), angeordnet auf einer Frontoberflächenseite der Vielzahl der Solarzellen;
ein Rückflächen-Schutzelement (180B), angeordnet auf einer Rückoberflächenseite der Vielzahl der Solarzellen;
ein Vorderflächen-Einkapselungselement (170A), angeordnet zwischen der Vielzahl der Solarzellen und dem Vorderflächen-Schutzelement (180A); und
ein Rückflächen-Einkapselungselement (170B), angeordnet zwischen der Vielzahl der Solarzellen und dem Rückflächen-Schutzelement (180B).

## Revendications

1. Cellule photovoltaïque (1) comprenant :
un substrat de silicium (10) lequel est cristallin ;
une première couche d'oxyde de silicium (20) qui est disposée sur une première surface principale du substrat de silicium et comprend du phosphore en tant qu'impureté ; et
une première couche de silicium amorphe (30) se trouvant sur la première couche d'oxyde de silicium,
dans laquelle un premier profil de concentration en phosphore dans le sens de l'épaisseur entre la première couche de silicium amorphe (30) et le substrat de silicium (10) a une valeur maximale dans la première couche d'oxyde de silicium (20).

2. Cellule photovoltaïque selon la revendication 1,
dans laquelle la première couche de silicium amorphe (30) comprend : une première couche de silicium amorphe intrinsèque (31) qui est substantiellement intrinsèque et se trouve sur la première couche d'oxyde de silicium ; et une première couche de silicium amorphe conductrice (32) qui se trouve sur la première couche de silicium amorphe intrinsèque et comprend un dopant d'un premier type de conductivité.

3. Cellule photovoltaïque selon la revendication 1 ou 2,
dans laquelle, dans la première couche d'oxyde de silicium (20),
la concentration atomique en phosphore est d'au moins 1 ×10¹⁹/cm³ et de tout au plus 5 × 10²⁰/cm³, et la concentration atomique en oxygène est d'au moins 1 × 10²¹/cm³ et de tout au plus 2 × 10²²/cm³.

4. Cellule photovoltaïque selon la revendication 1 ou 2,
dans laquelle, dans la première couche d'oxyde de silicium (20), la concentration atomique en phosphore est d'au moins 5 × 10¹⁹/cm³ et de tout au plus 1 × 10²⁰/cm³, et la concentration atomique en oxygène est d'au moins 2 × 10²¹/cm³ et de tout au plus 5 × 10²¹/cm³.

5. Cellule photovoltaïque selon l'une quelconque des revendications 1 à 4, dans laquelle le substrat de silicium (10) comprend, dans la première surface principale, une zone de diffusion présentant une concentration en phosphore supérieure à celle du substrat de silicium.

6. Cellule photovoltaïque selon l'une quelconque des revendications 1 à 5, comprenant en outre une deuxième couche de silicium amorphe (60) se trouvant sur une deuxième surface principale du substrat de silicium, qui est dos à dos à la première surface principale.

7. Cellule photovoltaïque selon la revendication 6,
dans laquelle la deuxième couche de silicium amorphe comprend : une deuxième couche de silicium amorphe intrinsèque (61), qui est substantiellement intrinsèque et qui se trouve sur le substrat de silicium ; et une deuxième couche de silicium amorphe conductrice se trouvant sur la deuxième couche de silicium amorphe intrinsèque et comprend un dopant d'un deuxième type de conductivité.

8. Cellule photovoltaïque selon la revendication 1,
dans laquelle la première couche de silicium amorphe (30) comprend : une première couche de silicium amorphe intrinsèque (31), laquelle est substantiellement intrinsèque et se trouve en contact (20) avec la première couche d'oxyde de silicium (20) et une première couche de silicium amorphe conductrice (32) se trouvant sur la première couche de silicium amorphe intrinsèque et comprend un dopant d'un premier type.

9. Module de cellule photovoltaïque (100) comprenant :
une pluralité de cellules photovoltaïques (1) selon l'une quelconque des revendications 1 à 8, lesquelles sont rangées dans deux dimensions :
un élément protecteur de surface avant (180A) se trouvant sur un côté de surface avant de la pluralité des cellules photovoltaïques;
un élément protecteur de surface arrière (180B) se trouvant sur un côté de surface arrière de la pluralité des cellules photovoltaïques;
un élément d'encapsulage de surface avant (170A) se trouvant entre la pluralité des cellules photovoltaïques et l'élément protecteur de surface avant (180A) ; et
un élément d'encapsulage de surface arrière (170B) se trouvant entre la pluralité des cellules photovoltaïques et l'élément protecteur de surface arrière (180B).
